# EUROPEAN PATENT APPLICATION

(11) **EP 2 572 878 A1**
(43) Date of publication of application: **27.03.2013**
(21) Application number: 10851551.1
(22) Date of filing: 20.05.2010
(51) Int. Cl.: B32B 27/06, H01L 33/00, C09K 11/00

(54) **RELEASABLE LIGHT-CONVERTING LUMINESCENT FILM**

(71) Applicant: Dalian Luminglight Co., Ltd., Liaoning 116025 (CN)
(72) Inventor: XIAO, Zhiguo, Dalian, Liaoning 116025 (CN); LI, Maolong, Dalian, Liaoning 116025 (CN); CHANG, Ying, Dalian, Liaoning 116025 (CN); SUI, Yulong, Dalian, Liaoning 116025 (CN); DAI, Xingjian, Dalian, Liaoning 116025 (CN); WU, Yuening, Dalian, Liaoning 116025 (CN); ZHANG, Hongwei, Dalian, Liaoning 116025 (CN)
(74) Representative: De Vries & Metman
(86) International application number: PCT/CN2010/000716
(87) International publication number: WO 2011/143792

(57) **Abstract**

Present invention provides a peelable light conversion luminescent film consisting of a substrate and a light conversion coating layer thereon; the light conversion coating layer consists of a fluorescent material, a two-component silicone resin, a diluents and an adjuvant; wherein the substrate is fluorine-containing polyester film which can be easily peeled off from the light conversion coating layer when using the light conversion film. The fluorine-containing polyester film can function as a substrate and as a protective film. The fluorine-containing polyester film can be easily peeled off to avoid the deformation of light conversion coating layer. After the peeling off from the fluorine-containing polyester film, the light refraction is reduced and the luminescent efficiency is increased. The fluorescent material is pretreated with ethanol-alkoxy oligomeric polysiloxane mixture solution, its compatibility with silicone resin is enhanced, the surface condition of the coated film is improved, and the uniformity of the film is increased.

## Description

### Technical field

The present invention belongs to LED display and illumination technical field. Present invention relates to a peelable light convention luminescent film of fluorescent materials, which can convert blue light emitted from LED to white light, and particularly to a layered product fabricated from a luminescent material, a luminescent coating material and resin films. The invention also relates to a peelable light conversion luminescent film for a luminescent device, including LED back light, digital display and illumination.

### Background art

Present LED back light, digital display and illumination devices are usually obtained by encapsulating fluorescent materials. There are many patents concerning such devices such as CN1941431 (White-light luminescent component and its production process), CN1510766 (Surface-mounting White light emitting diodes), and CN101186818 (Blue-purple light or blue light excitation fluorophor, preparation method thereof, and packaged white light diode), which all relate to white luminescent devices fabricated by mixing fluorescent materials in resins and coating on LED chips. The white luminescent devices fabricated by the method are difficult to ensure consistence of brightness, colour coordinate, colour temperature and colour rendering index. Moreover, since phosphor is close to the chip, it is easily aged due to influence of heat, and its service life is decresed. W02007105853 discloses a method for fabricating photoluminescent film, wherein the luminescent material employed is an inorganic luminescent material. In this patent the film is fabricated on a substrate film by coating method. This patent does not introduce specific technical processes, and the photoluminescent film is combined with the substrate as a whole. Since the refractive index of substrate material is inconsistent with that of photoluminescent layer, part of luminous efficiency will be lost during usage. W02007049187 discloses an encapsulant film containing a phosphor doped with silicone, this film material is mounted on a blue light LED to achieve the purpose of converting blue light to white light. However, this material is a film structure per se, therefore, it needs to perform secondary molding by lamination method depending on practical requirements, and thus the process is complex. US6600175B1 mentions that in the encapsulation of white light LED, an organic phosphor and a phosphor material are used to replace LED phosphor for encapsulation, and a white light is emitted. It only relates to the coating of single device and can only simply achieve electro-optical source, but has difficulties when employing in area light source. CN101533882A discloses a phosphor preformed film for white light LED and a method for preparing the same. The fabrication is performed by screen printing method, and thus it is impossible to achieve a continuous process and large area film production. CN101443192A discloses a photoluminescent sheet. In order to protect the matrix resin layer and improve heat resistance and moisture resistance, the photoluminescent sheet preferably uses PET polyester film as a protection film. Although the photoluminescent sheet can be used after the protection film is removed, the adhered protection film is usually retained for protection. Additionally, the photoluminescent sheet is fabricated by printing a mixture liquor of phosphor and silicone resin, whose viscosity is adjusted appropriately, on the protection film through screen printing, slit coating, roller coating or the like. The resulting photoluminescent sheet usually has a thin luminescent coating layer; and it is difficult for producing thick luminescent coating layer.

### Summary of the invention

The object of the present invention is to provide a peelable light conversion film. The film uses fluorine-containing polyester film as a substrate and a protection film. It is easily peelable when a light conversion film is applied. The fabricated peelable light conversion film has high uniformity, good light uniformity, glare resistance, high light conversion efficiency, low production cost, excellent aging resistance, and simple production process.

The peelable light conversion luminescent film according to present invention consists of a substrate and a light conversion coating layer thereon. The light conversion coating layer consists of a fluorescent material, two-component silicone resin, a diluent and an adjuvant. The substrate is fluorine-containing polyester film, which is used as a substrate in the fabrication of light conversion luminescent film and acts as a protection film, and which can be easily peeled off from the light conversion coating layer upon use. Since the fluorine-containing polyester film is used as a substrate, it can function as a production substrate for coating and a protective film in the fabrication of light conversion luminescent film. Additionally, the main resin used in the light conversion coating layer is silicone resin, which resin per se is flexible and elastic, and easily deforms when the protection film is peeled off. Thus the resulting light conversion film is not uniform in thickness, and the illumination performance is influenced. Hence, the present invention employs fluorine-containing polyester film as a substrate and a protection film. Upon use the light conversion coating layer can be easily peeled off from the fluorine-containing polyester film, and thereby avoiding the deformation caused by tension and ensuring the uniformity and stability of light conversion film products.

The fluorine-containing polyester film is a polyester film coated with fluorine-containing releasing agent on the surface, with a thickness of preferably 20-100µm. The fluorine-containing polyester film is used as a substrate in the fabrication of light conversion luminescent film, and can be easily peeled off from the light conversion coating layer upon use, such that a blue light source directly radiates on the light conversion luminescent film, thus the refraction of light in the fluorine-containing polyester film is reduced, and the overall luminescent efficiency is incerased.

The fluorescent material can be excited by blue light and is one or two selected from the group consisting of aluminate fluorescent material, silicate fluorescent material, siliconitride fluorescent material and oxysulfide fluorescent material. The fluorescent material is excited by a blue light LED which acts as the exciting light source and has a peak wavelength of emission spectrum within 440-475 nm; and the fluorescent material emits an emission spectrum with at least one peak wavelength within 525-650 nm. The light emitted from the fluorescent materials and the light emitted from blue light LED are combined into a white light or other color of light.

The fluorescent material used in present invention should be treated with ethanol-alkoxy oligomeric polysiloxanes mixture solution. The treated fluorescent materials have improved compatibility with silicone resin, and the surface condition of the coated film is improved.

The treatment method of the fluorescent material is a heat treating method. The concrete steps are: adding a fluorescent material and ethanol at a ratio to a reactor at 80-90°C while stirring, then adding an alkoxy oligomeric polysiloxane to the reactor, mixing with the powder by stirring, filtering the treated mixture solution and drying, the resulting fluorescent material can be directly used in the fabrication of light conversion coating.

The silicone resin employed in the present invention is a transparent, flexible, elastic bicomponent addition-type heat curable liquid silicone resin. This resin has good thermal oxidation stability, excellent electrical insulation performance, and improved moisture resistance, water-proof, rust prevention, low temperature resistance, ozone resistance and weathering resistance. The resin does not change yellow when working at high temperature for long time, and still has good flexibility and high strength after being cured. The silicone resin employed in present invention is preferably silicone resin having a viscosity of 3000-5000 cp.s and a transmittance of > 85%.

The fabrication process of the peelable light conversion luminescent film according to the present invention comprises: treating the fluorescent material with ethanol-alkoxy oligomeric polysiloxanes mixture solution; mixing the treated fluorescent material, a two-component silicone resin, a diluent and an adjuvant in a ratio and grinding to be uniformly dispersed; after filtering and defoaming, coating the mixture on the surface of a fluorine-containing polyester; and curing to obtain a product; the curing is thermocuring molding, and the curing temperature is 150-200°C.

The diluent is one or more selected from the group consisting of toluene, xylene, butyl ester, ethyl ester, methyl silicone oil, dimethyl silicone oil, ethyl silicone oil, phenyl silicone oil, and methylphenyl silicone oil.

The adjuvant can be one or more selected from the group consisting of ultraviolet absorbent, stabilizer, leveling agent, defoaming agent, fire retarding agent, antisettling agent, wetting agent, and antistatic agent.

Present invention has the following advantageous effects:
1. The fluorine-containing polyester film in the peelable light conversion film is used as a substrate in the fabrication, and thus can act as a protective film; it can be easily peeled off upon use to avoid the deformation of light conversion coating layer, and the refraction of light is reduced and the luminescent efficiency is improved.
2. Since the fluorescent material used for preparing the peelable light conversion film is pretreated with ethanol-alkoxy oligomeric polysiloxanes mixture solution, its compatibility with silicone resin is enhanced, the surface state of the coated film and the uniformity of the film are improved.
3. The fabrication of peelable light conversion film by coating method can achieve different coating thickness requirements, thus light conversion films with different thickness can be fabricated. In addition, a continuous production can be achieved with high production efficiency. Additionally, since the coating method has no strict requirements on viscosity of the light conversion coating and the particle size of fluorescent materials, the production can be carried out easily.

### Embodiments

### Example 1

Pretreatment of fluorescent material: the fluorescent material and ethanol at a ratio of 1:4 were added to a reactor at 80°C while stirring; alkoxy oligomeric polysiloxane in an amount of 3% of the fluorescent material was added to the reactor, and stirred with the powders for 20 min; the treated powder solution was filtrated and dried to obtain a treated fluorescent material.

The treated fluorescent material and other raw materials are prepared into a mixture solution based on following formulation (mass percent):

| | |
|---|---|
| Two-component silicone resin | 5 |
| Xylene | 1 |
| Defoaming agent | 0.1 |
| Leveling agent | 0.1 |
| Aluminate fluorescent material | 2.5 |
| Water | 91.3 |

These raw materials were mixed and ground until it was uniformly dispersed, after filtrating and defoamed, the mixture was coated on the surface of a 20µm fluorine-containing polyester film, and cured to obtain a product. The curing was performed at a temperature of 150°C for 3 min.

### Example 2

Pretreatment of fluorescent material: the fluorescent material and ethanol at a ratio of 1:3 were added to a reactor at 90°C while stirring; alkoxy oligomeric polysiloxane in an amount of 4% of the fluorescent material was added to the reactor, and stirred with the powders for 30 min; the treated powder solution was filtrated and dried to obtain a treated fluorescent material.

The treated fluorescent material and other raw materials are prepared into a mixture solution based on following formulation (mass percent):

| | |
|---|---|
| Two-component silicone resin | 9 |
| Butyl ester | 0.4 |
| Xylene | 0.6 |
| Defoaming agent | 0.1 |
| Dispersing agent | 0.3 |
| Silicate fluorescent material | 4.2 |
| Water | 85.4 |

These raw materials were mixed and ground until it was uniformly dispersed, after filtrating and defoaming, the mixuture was coated on the surface of a 50µm fluorine-containing polyester film, and cured to obtain a product. The curing was performed at a temperature of 200°C for 2 min.

### Example 3

Pretreatment of fluorescent material: the fluorescent material and ethanol at a ratio of 1:3 were added to a reactor at 85°C while stirring; alkoxy oligomeric polysiloxane in an amount of 2% of the fluorescent material was added to the reactor, and stirred with the powders for 20 min; the treated powder solution was filtrated and dried to obtain a treated fluorescent material.

The treated fluorescent material and other raw materials are prepared into a mixture solution based on following formulation (mass percent):

| | |
|---|---|
| Two-component silicone resin | 7 |
| Ethyl ester | 0.4 |
| Xylene | 0.4 |
| Defoaming agent | 0.1 |
| Wetting agent | 0.2 |
| Dispersing agent | 0.4 |
| Siliconitride fluorescent material | 4.0 |
| Water | 87.5 |

These materials were mixed and ground until it was uniformly dispersed, after filtrating and defoaming, the mixture was coated on the surface of a 100µm fluorine-containing polyester film, and cured to obtain a product. The curing was performed at a temperature of 180°C for 2 min.

### Example 4

Pretreatment of fluorescent material: the fluorescent material and ethanol at a ratio of 1:3 were added to a reactor at 90°C while stirring; alkoxy oligomeric polysiloxane in an amount of 4% of the fluorescent material was added to the reactor, and stirred with the powders for 30 min; the treated powder solution was filtrated and dried to obtain a treated fluorescent material.

The treated fluorescent material and other raw materials are prepared into a mixture solution based on following formulation (mass percent):

| | |
|---|---|
| Two-component silicone resin | 5 |
| Methyl silicone oil | 0.5 |
| Dimethyl silicone oil | 0.5 |
| Defoaming agent | 0.1 |
| Antisetting agent | 0.1 |
| Oxysulfides fluorescent material | 2.0 |
| Water | 91.8 |

These materials were mixed and ground until it was uniformly dispersed, after filtrating and defoaming, the mixure was coated on the surface of a 75µm fluorine-containing polyester film, and cured to obtain a product. The curing was performed at a temperature of 200°C for 1.5 min.

### Example 5

Pretreatment of fluorescent material: the fluorescent material and ethanol at a ratio of 1:4 were added to a reactor at 80°C while stirring; alkoxy oligomeric polysiloxane in an amount of 3% of the fluorescent material was added to the reactor, and stirred with the powders for 20 min, the treated powder solution was filtrated and dried to obtain a treated fluorescent material.

The treated fluorescent material and other raw materials are prepared into a mixture solution based on following formulation (mass percent):

| | |
|---|---|
| Two-component silicone resin | 5 |
| Ethyl silicone oil | 1 |
| Defoaming agent | 0.1 |
| Leveling agent | 0.1 |
| Aluminate fluorescent material | 2.5 |
| Water | 91.3 |

These materials were mixed and ground until it was uniformly dispersed, after filtrating and defoaming, the mixure was coated on the surface of a 20µm fluorine-containing polyester film, and cured to obtain a product. The curing was performed at a temperature of 150°C for 3 min.

### Example 6

Pretreatment of fluorescent material: the fluorescent material and ethanol at a ratio of 1:3 were added to a reactor at 90°C while stirring; alkoxy oligomeric polysiloxane in an amount of 4% of the fluorescent material was added to the reactor, and stirred with the powder for 30 min, the treated powder solution was filtrated and dried to obtain a treated fluorescent material.

The treated fluorescent material and other raw materials are prepared into a mixture solution based on following formulation (mass percent):

| | |
|---|---|
| Two-component silicone resin | 9 |
| Phenyl silicone oil | 0.8 |
| Methylphenyl silicone oil | 0.2 |
| Defoaming agent | 0.1 |
| Dispersing agent | 0.3 |
| Siliconitride fluorescent material | 4.2 |
| Water | 85.4 |

These materials were mixed and ground until it was uniformly dispersed, after filtrating and defoaming, the mixure was coated on the surface of a 50µm fluorine-containing polyester film, and cured to obtain a product. The curing was performed at a temperature of 200°C for 2 min.

### Example 7

Pretreatment of fluorescent material: the fluorescent material and ethanol at a ratio of 1:3 were added to a reactor at 90°C while stirring, alkoxy oligomeric polysiloxanes in an amount of 4% of the fluorescent material was added to the reactor, and stirred with the powder for 30 min, the treated powder solution was filtrated and dried to obtain treated fluorescent material.

The treated fluorescent material and other raw materials are prepared into a mixture solution based on following formulation (mass percent):

| | |
|---|---|
| Two-component silicone resin | 5 |
| Ethyl ester | 0.2 |
| Toluene | 0.8 |
| Defoaming agent | 0.1 |
| Antisetting agent | 0.1 |
| Aluminate fluorescent material | 2.0 |
| Water | 91.8 |

These materials were mixed and ground until it was uniformly dispersed, after filtrating and defoaming, the mixuture was coated on the surface of a 75µm fluorine-containing polyester film, and cured to obtain a product. The curing was performed at a temperature of 200°C for 1.5 min.

### Example 8

Pretreatment of fluorescent material: the fluorescent material and ethanol at a ratio of 1:3 were added to a reactor at 85°C while stirring, alkoxy oligomeric polysiloxanes in an amount of 2% of the fluorescent material was added to the reactor, and stirred with the powder for 20 min, the treated powder solution was filtrated and dried to obtain treated fluorescent material.

The treated fluorescent material and other raw materials are prepared into a mixture solution based on following formulation (mass percent):

| | |
|---|---|
| Two-component silicone resin | 7 |
| Butyl ester | 0.4 |
| Toluene | 0.2 |
| Defoaming agent | 0.1 |
| Wetting agent | 0.2 |
| Dispersing agent | 0.4 |
| Aluminate fluorescent material | 4.0 |
| Water | 87.7 |

These materials were mixed and ground until it was uniformly dispersed, after filtrating and defoaming coated on the surface of a 100µm fluorine-containing polyester film, and cured to obtain a product. The curing was performed at a temperature of 180°C for 2 min.

## Claims

1. A peelable light conversion luminescent film consisting of a substrate and a light conversion coating layer thereon, the light conversion coating layer consisting of a fluorescent material, two-component silicone resin, a diluent and an adjuvant, **characterized in that** the substrate is a fluorine-containing polyester film, and the fluorine-containing polyester film is easily peeled off from the light conversion coating layer when the light conversion film is used.

2. The peelable light conversion luminescent film according to claim 1, **characterized in that** the fluorine-containing polyester film is a polyester film coated with fluorine-containing releasing agent on the surface.

3. The peelable light conversion luminescent film according to claim 1, **characterized in that** the fluorine-containing polyester has a total thickness of 20-100µm.

4. The peelable light conversion luminescent film according to claim 1, **characterized in that** the fluorescent material can be excited by blue light and is one or two selected from the group consisting of aluminate fluorescent material, silicate fluorescent material, siliconitride fluorescent material and oxysulfide fluorescent material; the fluorescent materials is excited by a blue light LED, which acts as the exciting light source and has a peak wavelength of emission spectrum within 440-475 nm, and the fluorescent material emits an emission spectrum with at least one peak wavelength within 525-650 nm; the light emitted from the fluorescent materials and the light emitted from blue light LED are combined into a white light or other color light.

5. The peelable light conversion luminescent film according to claim 1, **characterized in that** the fluorescent material is treated with ethanol-alkoxy oligomeric polysiloxanes mixture solution.

6. The peelable light conversion luminescent film according to claim 1, **characterized in that** the diluent is one or more selected from the group consisting of toluene, xylene, butyl ester, ethyl ester, methyl silicone oil, dimethyl silicone oil, ethyl silicone oil, phenyl silicone oil, and methylphenyl silicone oil.

7. The peelable light conversion luminescent film according to claim 1, **characterized in that** the adjuvant is one or more selected from the group consisting of ultraviolet absorbent, a stabilizer, a leveling agent, a defoaming agent, a fire retarding agent, an antisettling agent, a wetting agent, and an antistatic agent.

8. A method for fabricating the peelable light conversion luminescent film according to any one of claims 1-7, comprising the steps of:
treating the fluorescent material with an ethanol-alkoxy oligomeric polysiloxane mixture solution;
mixing the treated fluorescent material, a two-component silicone resin, a diluent and an adjuvant in a ratio and grinding until it is uniformly, filtering and defoaming to produce a fluorescent material dispersion; and
coating the fluorescent material dispersion on the surface of the fluorine-containing polyester film, and curing to obtain a product, wherein the curing is thermocuring molding, and the curing temperature is 150-200°C.

9. The method according to claim 8, **characterized in that** the fluorine-containing polyester film is a polyester film coated with fluorine-containing releasing agent on the surface.

10. The method according to claim 8, **characterized in that** the fluorine-containing polyester has a total thickness of 20-100µm.

11. The method according to claim 8, **characterized in that** the diluent is one or more selected from the group consisting of toluene, xylene, butyl ester, ethyl ester, methyl silicone oil, dimethyl silicone oil, ethyl silicone oil, phenyl silicone oil, and methylphenyl silicone oil.

12. The method according to claim 8, **characterized in that** the adjuvant is one or more selected from the group consisting of ultraviolet absorbent, a stabilizer, a leveling agent, a defoaming agent, a fire retarding agent, an antisettling agent, a wetting agent, and an antistatic agent.
